# EUROPÄISCHE PATENTSCHRIFT

(11) **EP 3 208 634 B1**
(45) Veröffentlichungstag und Bekanntmachung des Hinweises auf die Patenterteilung: **15.08.2018**
(21) Anmeldenummer: 16156068.5
(22) Anmeldetag: 17.02.2016
(51) Int. Cl.: G01S 15/93, G01S 7/523

(54) **ULTRASCHALLMESSSYSTEM, INSBESONDERE ZUR ABSTANDSMESSUNG UND/ODER ALS PARKHILFE BEI FAHRZEUGEN**
ULTRASOUND MEASURING SYSTEM, IN PARTICULAR FOR DISTANCE MEASUREMENT AND/OR AS PARKING AID IN VEHICLES
SYSTEME DE MESURE D'ULTRASONS, EN PARTICULIER DESTINE A MESURER LA DISTANCE ET/OU EN TANT QU'AIDE AU STATIONNEMENT DANS DES VEHICULES AUTOMOBILES

(43) Veröffentlichungstag der Anmeldung: 23.08.2017
(73) Patentinhaber: ELMOS Semiconductor Aktiengesellschaft, 44227 Dortmund (DE)
(72) Erfinder: Schmidt, Andre, 44227 Dortmund (DE); Spiegel, Egbert, Dr., 44227 Dortmund (DE); Schlautmann, Guido, 44227 Dortmund (DE); Heppekausen, Stefanie, 44227 Dortmund (DE)
(74) Vertreter: dompatent von Kreisler Selting Werner - Partnerschaft von Patent- und Rechtsanwälten mbB

(56) Entgegenhaltungen:
- WO-A1-2014/166835
- DE-A1- 2 935 038
- DE-A1- 10 136 628
- DE-A1-102011 017 601
- DE-A1-102014 202 869

## Beschreibung

Die Erfindung betrifft ein Ultraschallmesssystem, das sich insbesondere für die Abstandsmessung und/oder als Parkhilfe bei Fahrzeugen eignet.

Ultraschallmesssysteme werden insbesondere für Abstands-bzw. Entfernungsmessungen eingesetzt. Ein wesentlicher Einsatzbereich solcher Ultraschallmesssysteme ist ihre Verwendung als Parkhilfe für Fahrzeuge.

Ganz allgemein gilt für Ultraschallmesssysteme, dass Ultraschallwellen von einem Ultraschallsender ausgesendet werden, die, wenn sie auf ein Hindernis auftreffen, von diesem reflektiert und von einem Ultraschallempfänger empfangen werden. Aufgrund der Laufzeit zwischen dem Aussenden der Ultraschallwellen und dem Empfang von Echos der Ultraschallwellen kann dann auf die Entfernung des Hindernisses zum Ultraschallsender bzw. -empfänger geschlossen werden. Ultraschallmesssysteme werden aber auch zur Überwachung von Räumen und zur Detektion von sich in überwachten Räumen aufhaltenden Personen eingesetzt.

Um auch noch Echosignale, die von weiter entfernten Objekten herrühren, zuverlässig detektieren zu können, sollte die Energie der ausgesendeten Ultraschallwellen ausreichend groß sein. Daher werden elektroakustische Ultraschallwandler derartiger Ultraschallsysteme am Eingang mit einem Transformator bzw. Spannungsumsetzer betrieben. Damit aber steigen die Herstellungskosten von Ultraschallwandlern, was sich insbesondere bei Parkhilfen für Fahrzeuge insoweit negativ auswirkt, als derartige Parkhilfen zumeist mehrere Ultraschallwandler umfassen.

Ein Ultraschallmesssystem kann beispielsweise einen Ultraschallsender und einen Ultraschallempfänger aufweisen, die als getrennte Einzelkomponenten ausgebildet sind. Wesentlich vorteilhafter ist es insbesondere unter dem Aspekt eines verringerten Platzbedarfs und geringerer Gestehungskosten jedoch, wenn ein Ultraschallwandler eingesetzt wird, der in einem Sendeintervall als Ultraschallsender und in einem zeitlich nach dem Sendeintervall liegenden Empfangsintervall als Ultraschallempfänger arbeitet. Innerhalb des Sendeintervalls wird der Ultraschallwandler insbesondere mittels eines Burst-Ansteuersignals angesteuert, wodurch ein elektroakustisches Schwingelement des Ultraschallwandlers in Schwingung versetzt und damit angeregt wird. Nach Beendigung dieser Ansteuerung schwingt das Schwingelement allerdings zunächst aus. Während dieser Zeit können Echos, die von nahe zum Ultraschallwandler angeordneten Objekten kommen, nicht mit Sicherheit detektiert werden, so dass mit dem zuvor genannten Typ von Ultraschallwandlern nur bedingt im Nahbereich gemessen werden kann.

Es ist bekannt, zur Verkürzung der Ausschwingzeit eines Ultraschallwandlers dessen Schwingelement zu dämpfen (siehe EP-B-0 571 566, EP-B-0 623 395, WO-A-2012/163598, US-B-6 731 569 und GB-A-2 483 337). Hierzu wird z.B. nach DE-A-36 02 857 bei einem Ultraschallwandler ein Widerstand zugeschaltet, und zwar bereits innerhalb des Sendeintervalls.

In WO-A-2014/166835 ist beschrieben, den Ultraschallwandler mit Beendigung des Sendeintervalls und/oder mit Beginn des Empfangsintervalls mit Gegenpulsen anzusteuern.

Nach DE-A-10 2009 027 221 und DE-A-10 2010 039 017 wird das Schwingelement mit einem oder mehreren Dämpfungspulsen beaufschlagt.

In DE-A-101 36 628 und DE-A-10 2014 202 869 sind weitere Verfahren und Vorrichtungen zur Ansteuerung eines Ultraschallwandlers beschrieben. Aus DE-A-10 2011 017 601 ist ein Ansteuerverfahren für einen Wechselrichter und Wechselrichteranordnung, insbesondere Solarzelleninverter und aus DE-A-29 35 038 ist eine Schaltungsanordnung zur Erzeugung einer sinusförmigen Wechselspannung konstanter Frequenz aus einer Gleichspannung bekannt.

Aus Gründen der vereinfachten Realisierung eines zuverlässigen ESD-Schutzes ist es bekannt, einen der beiden Anschlüsse eines Ultraschallwandlers mit Massepotential zu verbinden. Für seinen Betrieb als Ultraschallsender wird der Ultraschallwandler an dem anderen Signalanschluss mit einer Wechselspannung um 0V herum angesteuert. Sofern eine ausreichend große Betriebsspannung zur Verfügung steht, bereitet dies keine weiteren Schwierigkeiten, da beispielweise zwischen 0 V und der Betriebsspannung ein für den Betrieb des Ultraschallwandlers als Sender ausreichender Spannungshub zur Verfügung steht.

Anders sieht die Situation aus, wenn die Betriebsspannung, wie beispielsweise beim Bordnetz von Fahrzeugen begrenzt ist (beispielsweise 12 V). In diesem Fall ist es erforderlich, aus der Bordspannung eine Wechselspannung mit positiven und negativen Werten (bspw. +/- 40 V) zu erzeugen.

Aufgabe der Erfindung ist es, ein Ultraschallmesssystem zu schaffen, das unter den oben genannten Randbedingungen mit nur geringem Hardware-Aufwand realisiert werden kann.

Zur Lösung dieser Aufgabe wird mit der Erfindung ein System vorgeschlagen, das versehen ist mit den Merkmalen des Anspruchs 1. Einzelne Ausgestaltungen der Erfindung sind Gegenstand der Unteransprüche.

Die Erfindung geht von der Verwendung eines elektroakustischen Ultraschallwandlers aus, der ohne Spannungsumsetzer bzw. Transformator betrieben und über lediglich einen seiner typischerweise zwei Anschlüsse angesteuert wird bzw. der an diesem besagten einen Anschluss bei Empfang von Ultraschallwellen ein Signal ausgibt. Der Ultraschallwandler weist ein Schwingelement auf, das während eines Sendeintervalls zum Schwingen angeregt wird, also als Aktuator dient und damit Ultraschallwellen abgibt, und das in einem sich anschließenden Empfangsintervall auf empfangene Ultraschallwellen reagiert und damit angeregt wird, also als Sensor bzw. Empfänger dient. Der Ultraschallwandler wird von einer Ansteuer- und Auswerteeinheit angesteuert, wobei diese Einheit in dem Empfangsintervall vom Ultraschallwandler kommende Signale auswertet. Die Ansteuer- und Auswerteeinheit weist eine an eine Versorgungsgleichspannung angeschlossene Brückenschaltung mit Schaltern und einer umpolbaren Landungsspeicherkapazität auf. Die Ladungsspeicherkapazität wird entsprechend der erforderlichen Anregungsspannung des Ultraschallwandlers aufgeladen.

Die Brückenschaltung sorgt nun dafür, dass an den Signalanschluss des Ultraschallwandlers wahlweise ein positives Potential der Anregungsspannung und ein negatives Potential der Anregungsspannung angelegt werden. Zur Erzeugung des negativen Potentials der Anregungsspannung dient die Ladungsspeicherkapazität, deren negatives Spannungspotential alternierend an den Signalanschluss des Ultraschallwandlers angelegt wird.

Von Bedeutung bei Ultraschallwandlern der zuvor beschriebenen Art, die einerseits als Sender und kurz darauf als Empfänger arbeiten, ist es, dass sie eine möglichst kurze Ausschwingphase aufweisen. Zur Verkürzung der Ausschwingphase wird nun erfindungsgemäß vorgeschlagen, die Anregungsspannung an dem Ultraschallwandler zum Zeitpunkt des Endes des Sendeintervalls kurzzeitig, d. h. für die Dauer eines Ansteuerpulses auf 0 V zu setzen. Damit wird die Amplitude während der Ausschwingphase reduziert.

In vorteilhafter Weiterbildung der Erfindung ist vorgesehen, dass die Ansteuer- und Auswerteeinheit eine Dämpfungsinduktivität aufweist, die mittels der Ansteuer- und Auswerteeinheit frühestens mit dem Ende des Sendeintervalls aktiviert und während der Dauer der Ausschwingphase deaktiviert wird. Durch die Ansteuerung des Ultraschallwandlers mit einer Anregungsspannung von im wesentlichen 0 V liegt am Ultraschallwandler kurzzeitig und unmittelbar zum Ende des Sendeintervalls und damit unmittelbar vor Beginn der Aussschwingphase eine Spannung an, die größenmäßig in demjenigen Bereich liegt, in dem die Dämpfungsinduktivität effektiv arbeitet. Dadurch verkürzt sich die Ausschwingphase, so dass bereits Echos, die durch nahe dem Ultraschallwandler befindliche Objekte ausgelöst werden, erkannt werden können.

Die Ansteuer- und Auswerteeinheit ist im Regelfall als Teil eines IC ausgeführt. Die Realisierung von Induktivitäten in ICs ist problematisch. Daher ist es bekannt, in ICs Induktivitäten durch sogenannte Impedanzkonverterschaltungen zu realisieren. Ein Beispiel einer derartigen Impedanzkonverterschaltung (sogenannte elektronische Spule) ist beschrieben in "The Circuits And Filters Handbook", second Edition, Editor-in-Chief Way-Kay Chen, Seiten 394 - 397, 2003, CRC Press LLC, ISBN 0-8493-0912-3.

Zum Betrieb einer Impedanzkonverterschaltung ist eine Gleichspannung erforderlich. Da die Impedanzkonverterschaltung ihrerseits mit dem besagten Signalanschluss des Ultraschallwandlers verbunden sein muss, um die Dämpfungsfunktion ausüben zu können, kann zwischen der Impedanzkonverterschaltung und dem Signalanschluss des Ultraschallwandlers eine Entkopplungskapazität geschaltet sein. Ein weiterer Gesichtspunkt, die Betriebsspannung der Impedanzkonverterschaltung bzw. deren Ausgangsspannung gegenüber dem Ultraschallwandler zu entkoppeln, ist darin zu sehen, dass der Ultraschallwandler damit nicht dauerhaft mit einer Gleichspannung beaufschlagt ist, was sein Verhalten über die Lebensdauer beeinträchtigen könnte.

Während des Sendeintervals verändert sich allerdings die Ladung der Entkopplungskapazität, und zwar wegen der wechselnden Anregungsspannung für den Ultraschallwandler. Damit liegt also am Ende des Sendeintervals nicht mehr exakt 0 V am Ultraschallwandler an. Das wiederum beeinflusst das Ausschwingverhalten des Schwingelements.

Zumindest während der Ausschwingphase und während des Empfangsintervalls wird das am Ultraschallwandler anstehende Signal von einem Verstärker der Ansteuer- und Auswerteeinheit verstärkt, um anschließend hinsichtlich der Detektion von Echos ausgewertet zu werden. Kritisch für die Auswertung des verstärkten Signals ist die Ausschwingphase. Wenn nämlich das mittlere Ausschwingsignal nicht ausreichend schnell abklingt, könnte das Ausgangssignal des Verstärkers bzw. die Hüllkurve des Ausgangssignals das Vorhandensein eines "nahen" Hindernisses signalisieren, was aber tatsächlich nicht vorhanden ist.

Damit der Verstärker dem Ausschwingsignal schneller folgen kann, ist gemäß einer vorteilhaften Ausgestaltung der Erfindung zwischen dem Signalanschluss des Ultraschallwandlers und dem Eingang des Verstärkers ein Filter angeordnet, das eine umschaltbare Filterkonstante aufweist, um während der Ausschwingphase als Hochpass zu fungieren und zwar insbesondere nach der Deaktivierung der Dämpfungsfunktion. Die Filterkonstante wird nach einer bestimmten Zeit und gegen Ende der Ausschwingphase wieder zurückgesetzt.

Wie bereits oben erwähnt, weist die Ansteuer- und Auswerteeinheit eine Ladungsspeicherkapazität auf. Während des Sendeintervalls wird diese Ladungsspeicherkapazität über die Brückenschaltung intermittierend immer wieder mit der Betriebsspannung verbunden und damit aufgeladen. Vor Beginn des Sendeintervalls allerdings ist es zweckmäßig, die Ladungsspeicherkapazität über eine Stromquelle der Ansteuer- und Auswerteeinheit aufzuladen. Denn zu diesem Zeitpunkt ist die Ladungsspeicherkapazität weitgehend entladen, so dass vergleichsweise große Ladeströme fließen würden, die gegebenenfalls die Funktionstüchtigkeit der Schalter der Brückenschaltung beeinträchtigen könnten.

Die Erfindung wird nachfolgend anhand eines Ausführungsbeispiels und unter Bezugnahme auf die Zeichnung näher erläutert. Im Einzelnen zeigen dabei:
- Fig. 1: eine elektrische Schaltung, teilweise als Blockschaltbild, zur Ansteuerung eines Ultraschallwandlers und zur Auswertung von vom Ultraschallwandler empfangenen Echosignalen,
- Fig. 2: eine detailliertere Schaltung zur Verdeutlichung der in Fig. 1 mit Treiber, elektrischer Dämpfung und Receiver bezeichneten Blöcke,
- Fig. 3: ein Diagramm mit den Signalverläufen der verschiedenen Ultraschallwandler-Ansteuersignale und -Auswertesignale sowie Steuersignale für die diversen Schalter der Schaltung nach den Fign. 1 und 2,
- Fig. 4: die Schaltung gemäß Fig. 2 mit den Schalterstellungen in der Phasedes Aufladens der Ladungsspeicherkapazität im Vorfeld eines Sendein-tervalls,
- Fign. 5 und 6: die beiden Schalterstellungssituationen während eines Sendeintervalls, die alternierend aufeinanderfolgen,
- Fig. 7: die Schalterstellung am Ende eines Sendeintervalls nach Zuschalten der Dämpfung für das Ausschwingen,
- Fig. 8: die Schalterstellung am Ende eines Sendeintervalls zur Erzeugung eines Stopppulses,
- Fig. 9: die Schalterstellung am Ende eines Sendeintervalls zur Erzeugung eines Stopppulses gemäß einer dritten Variante und
- Fig. 10: die Schalterstellung in dem Fall, dass zur Verhinderung von Echo-Fehlinterpretationen oder Echo-Fehlinterpretationen wegen eines zu schnellen Einschwingens das Filter am Eingang des Verstärkers mit der umschaltbaren Filterkonstante betrieben wird.

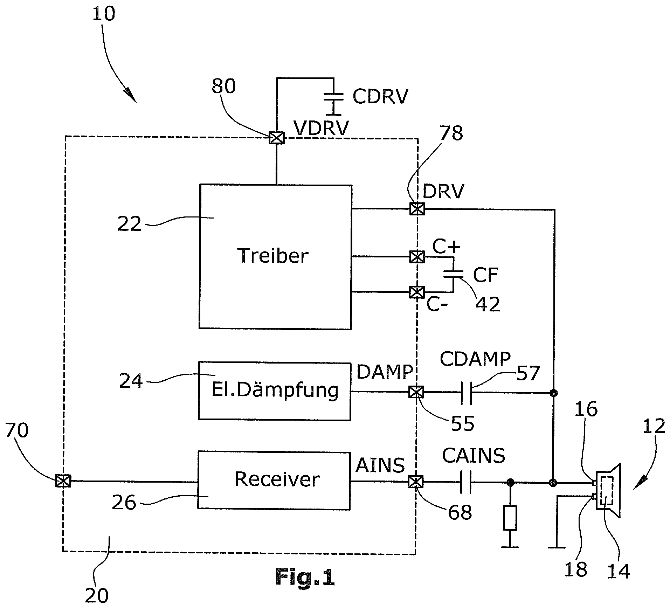

Fig. 1 zeigt als Blockschaltbild ein Ausführungsbeispiel für ein Ultraschallmesssystem 10 gemäß der Erfindung. Das Ultraschallmesssystem 10 weist einen Ultraschallwandler 12 mit einem Schwingelement 14 auf. Der Ultraschallwandler 12 wird wechselweise als Sender und als Empfänger betrieben. Dabei sei hervorgehoben, dass der Ultraschallwandler 12 ohne Spannungsumsetzer bzw. Transformator betrieben wird.

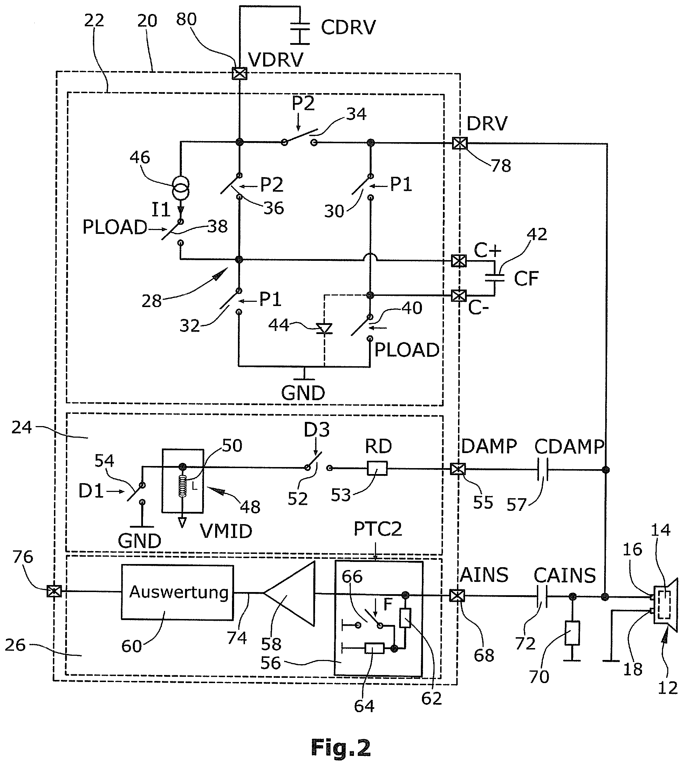

Der Ultraschallwandler 12 verfügt über zwei Anschlüsse, und zwar über einen Signalanschluss 16 und einen mit Masse verbundenen Masseanschluss 18. Am Signalanaschluss 16 liegt einerseits das von einer Ansteuer- und Auswerteeinheit 20 erzeugte Ansteuersignal zur Erzeugung von Ultraschallwellen in einem Sendeintervall und andererseits in einem Empfangsintervall das von Ultraschallwandler 12 beim Empfang von Echos der zuvor ausgesendeten Ultraschallwellen ausgegebene Messsignal an, das von der Ansteuer- und Auswerteeinheit 20 ausgewertet wird. Die Ansteuer- und Auswerteeinheit 20 lässt sich ganz grob unterteilen in eine Treiberstufe 22, eine Dämpfungsstufe 24 zu elektrischen Dämpfung und eine Verstärker- sowie Auswertestufe 26. Diese drei Funktionsgruppen werden nachfolgend schaltungstechnisch anhand von Fig. 2 erläutert.

Die Treiberstufe 22 weist eine Brückenschaltung 28 mit Schaltern 30, 32, 34, 36, 38, 40, einer Kapazität 42 und einer Diode 44 auf. Ferner weist die Treiberstufe 22 eine Stromquelle 46 auf. Die Dämpfungsstufe 24 für die elektrische Dämpfung ist versehen mit einer Impedanzkonverterschaltung 48 zur Realisierung einer Induktivität 50 in einer integrierten Schaltung (IC) sowie mit zwei Schaltern 52, 54 und einem Widerstand 53. Zur Dämpfungsstufe 24 gehört schließlich auch noch eine Entkopplungskapazität 57, was aber nicht zwingend erforderlich ist.

Die Entkopplungskapazität 57 ist zwischen den Ausgang 55 der Stufe 24 und den Signalanschluss 16 des Ultraschallwandlers 12 geschaltet.

Schließlich weist die Verstärker- und Auswertestufe 26 in Kombination mit der Kapazität 72 ein Filter 56, einen Verstärker 58 und eine Auswerteschaltung 60 auf. Der integrierte (IC-)Teil des Filters 56 ist in diesem Ausführungsbeispiel als Spannungsteiler mit zwei Widerständer 62, 64 und einem Schalter 66 ausgeführt, über den der Widerstand 64 mit Masse verbindbar und damit überbrückbar ist.

Zwischen dem Signalanschluss 16 des Ultraschallwandlers 12 und dem Eingang 68 der Verstärker- und Auswertestufe 26 sind ein gegen Masse geschalteter Widerstand 70 sowie eine Kapazität 72 geschaltet. Zusammen mit der Kapazität 72 wirkt das Filter als Hochpass.

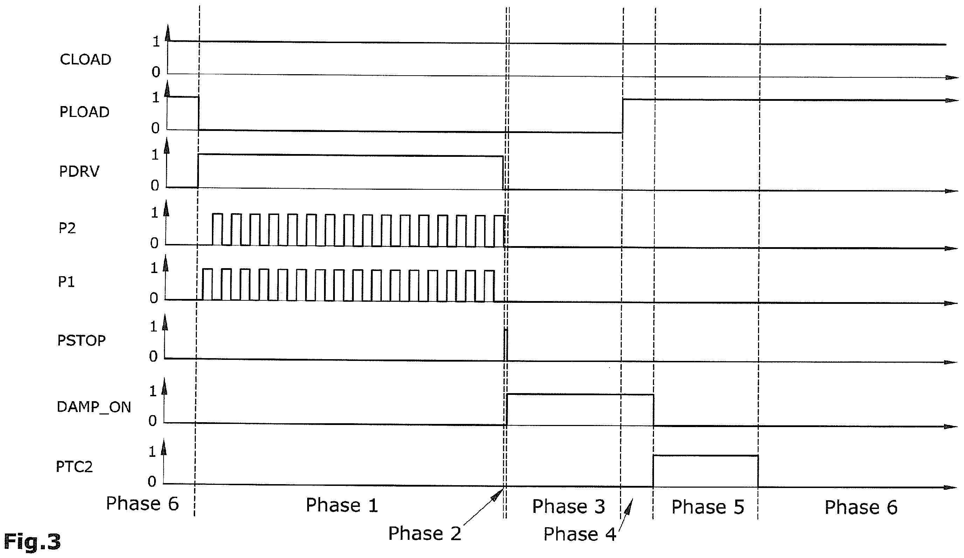

Fig. 3 zeigt die Signalverläufe der in Fig. 2 bezeichneten Ansteuersignale (der Kommentar würde nur für das noch nicht eingefügte Bild mit den Simulationskurve gelten). Ferner ist in Fig. 3 gezeigt, dass ein Ansteuer- und Auswertezyklus des Ultraschallmesssystems 10 ein Sendeintervall (Phase 1), einen Stopppuls (Phase 2), eine Ausschwingphase (Phasen 3 und 4 zum Dämpfen und Phase 5 zur Umschaltung der Filterkonstante) und ein Empfangsintervall (Phase 6) zum Empfang realer Echos umfasst. Die Gesamtdauer des Zyklus kann z. B. im ms-Bereich (z. B. 12 bis 15 ms) liegen, wobei die Dauer der Phasen 1 und 3 bis 5 jeweils etwa zwei Größenordnungen geringer sind (z. B. Phase 1 ca. 300 µs, Phasen 3 und 4 zusammen ca. 700 µs und Phase 5 ca. 180 µs). Die Phase 6 ist also mit Abstand die längste Phase des Zyklus.

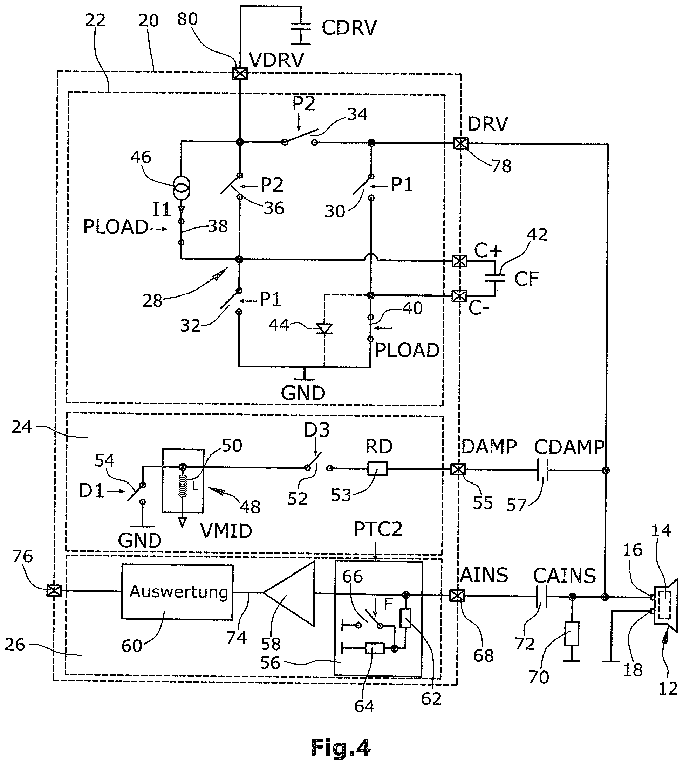

Fig. 4 zeigt die Situation im Vorfeld eines Sendeintervalls zum Aufladen der Ladungsspeicherkapazität 42. Die Schalter 38 und 40 sind geschlossen (bei geöffneten Schaltern 30, 32, 34, 36 der Brückenschaltung 28), so dass die Ladungsspeicherkapazität 42 durch den Strom I1 der Stromquelle 46 aufgeladen wird. Grundsätzlich wäre es möglich, in dieser Phase die Ladungsspeicherkapazität 42 statt durch die Stromquelle 46 durch Schließen des Schalters 36 und des Schalters 40 aufzuladen. Da die Ladungsspeicherkapazität 42 jedoch nahezu vollständig entladen ist, besteht die Gefahr, dass in der Anfangsphase des Aufladevorgangs über die Schalter 36 und 40 ein zu großer Strom fließen würde, der die Schalter 36, 40 zerstören könnte. Daher ist es zweckmäßig, den Aufladestrom durch die Stromquelle 46 sozusagen zu begrenzen. Nach Abschluss der Aufladephase werden die Schalter 38, 40 geöffnet.

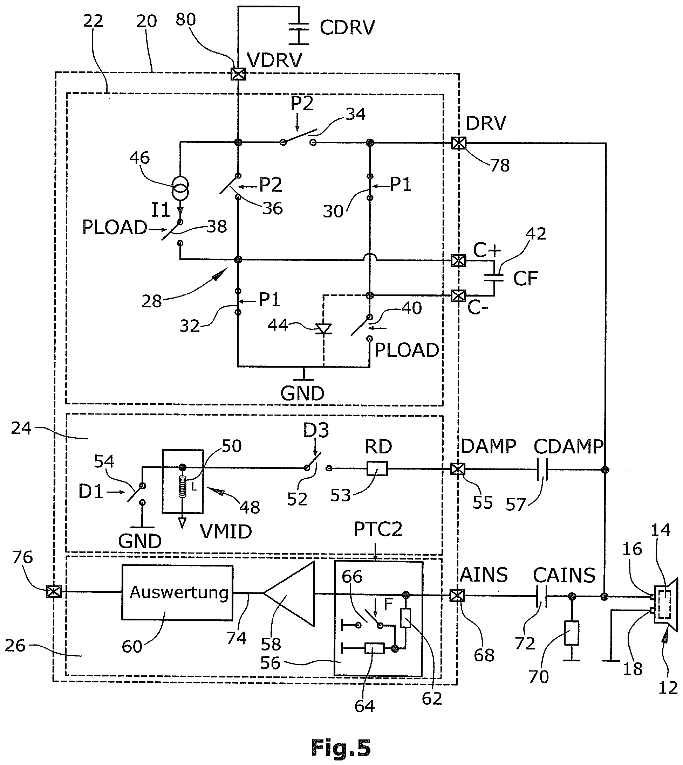

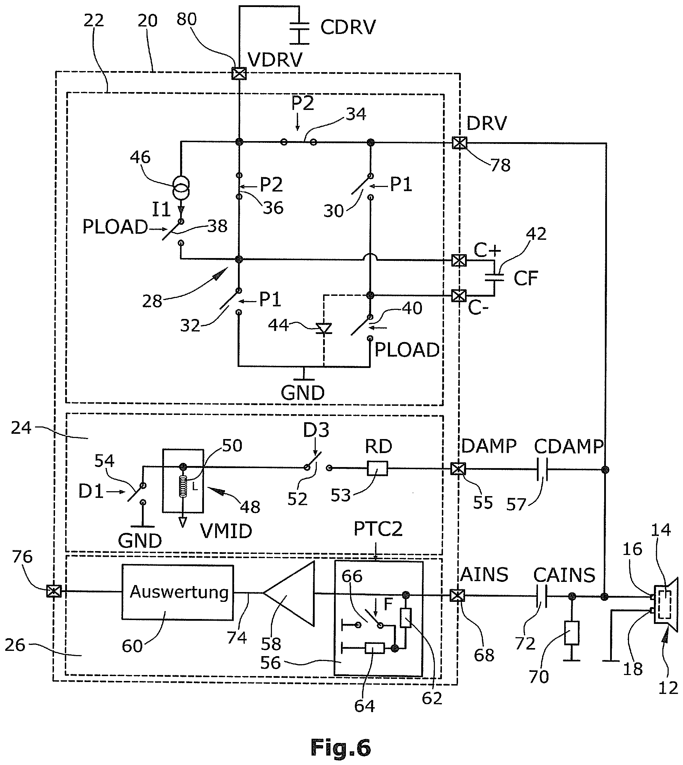

Fig. 5 zeigt die Schalterkonstellation in der Treiberstufe 22 zu Beginn des Sendeintervalls. Zunächst sind die Schalter 30, 32 geschlossen (und die Schalter 34, 36 offen), so dass das negative Potential an der Ladungsspeicherkapazität 42 mit dem Ausgang 78 der Treiberstufe 22 verbunden ist und damit am Signalanschluss 16 des Ultraschallwandlers 12 anliegt. Nachdem die Schalterstellung für einen kurzen Steuerpuls sich so, wie in Fig. 5 gezeigt, darstellt, erfolgt danach eine Umschaltung der Schalter gemäß Fig. 6. Nun sind die zuvor geschossenen Schalter 30, 32 geöffnet und die zuvor geöffneten Schalter 34, 36 geschlossen, so dass das Betriebsspannungspotential VDRV 80 am positiven Potentialanschluss der Ladungsspeicherkapazität 42 anliegt. Die Ladungsspeicherkapazität 42 wird somit intermittierend aufgeladen. Zugleich liegt aber auch das Betriebsspannungspotential 80 am Ausgang 78 der Treiberstufe 22 und damit am Signalanschluss 16 an.

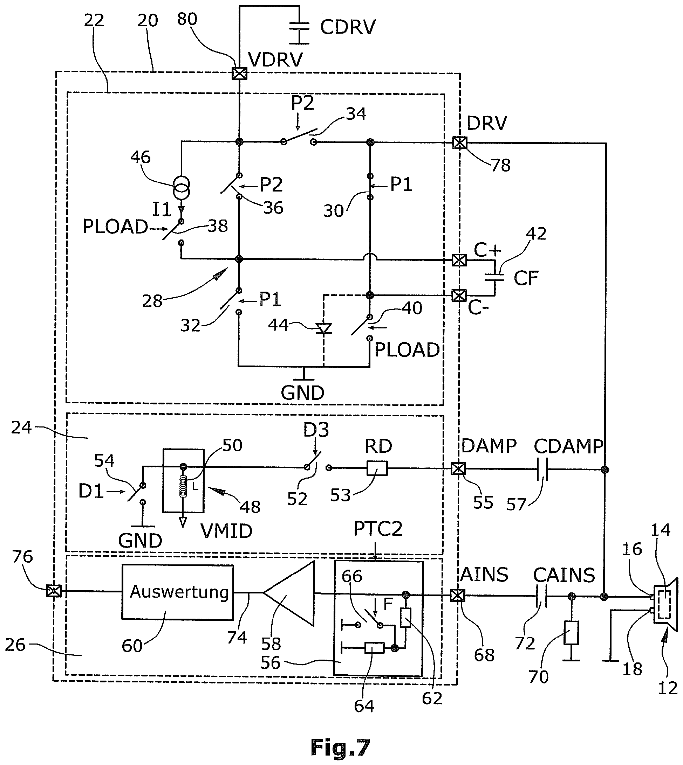

Gegen Ende bzw. genau am Ende des Sendeintervalls wird der Ausgang 78 der Treiberstufe 22 zwangsweise mit Massepotential, also mit 0 V versorgt. Dies erfolgt durch Schließen des Schalters 30 bei geöffneten Schaltern 32, 34, 36. Über die Diode 44 liegt der Ausgang 78 der Treiberstufe 22 an Masse (Fig. 7).

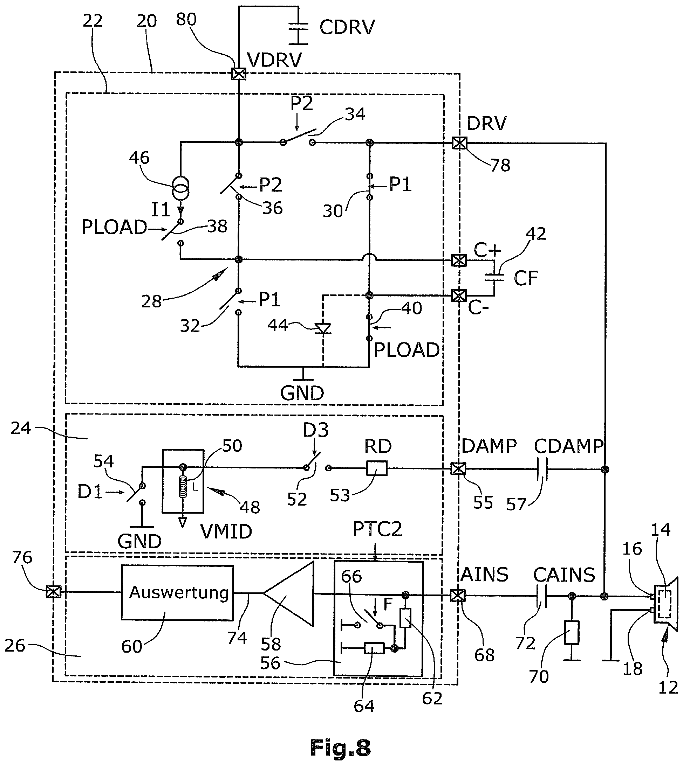

Fig. 8 zeigt eine Alternative für die pulsförmige Beaufschlagung des Ausgangs 78 der Treiberstufe 22 mit 0 V. Dies kann beispielsweise auch dadurch realisiert werden, dass die Schalter 30 und 40 geschlossen werden, während die Schalter 32, 34 und 36 geöffnet sind. Auch durch diese Schalterstellungen liegt letztendlich der Ausgang 78 der Treiberstufe 22 an Masse.

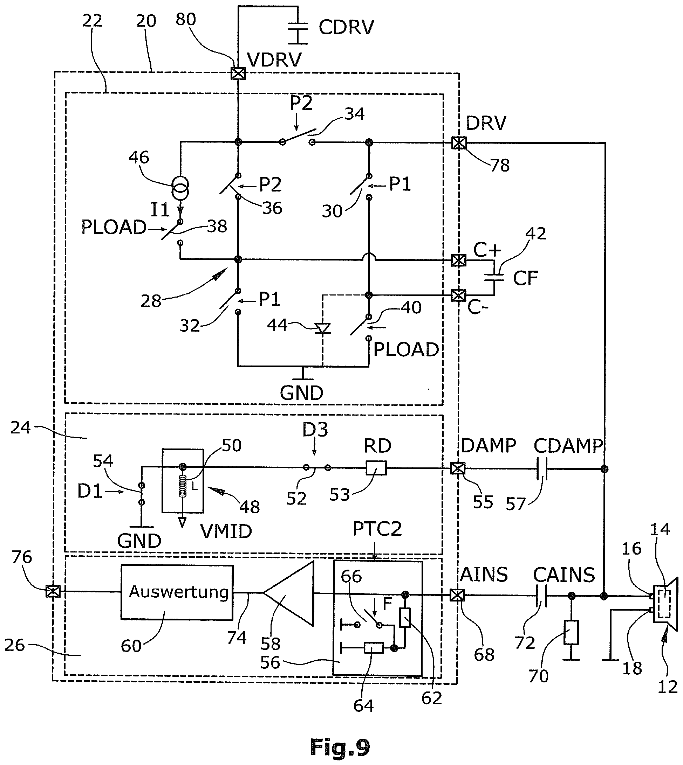

Fig. 9 schließlich zeigt eine Variante für die Stopppulserzeugung (kurzzeitige Beaufschlagung des Ausgangs 78 der Treiberstufe 22 mit 0 V), indem die Schalter 52, 54 der Dämpfungsstufe 24 geschlossen werden. Diese Variante lässt sich allerdings nur dann realisieren, wenn die Entkopplungskapazität 57 nicht vorhanden ist. Grundsätzlich gilt für die Entkopplungskapazität 57, dass diese die mittlere Betriebsspannung VMID der Impedanzkonverterschaltung 48 vom Signalanschluss 16 des Ultraschallwandlers 12 fernhält, was den Vorteil mit sich bringt, dass der Ultraschallwandler 12 während des Betriebs nicht dauerhaft mit einer Gleichspannung beaufschlagt wird. Die Betriebsspannung VMID wiederum wird aber benötigt, um mittels der Impedanzkonverterschaltung 48 die Dämpfungsinduktivität 50 zu realisieren. Die hier beschriebene Variante der Erzeugung eines Stopppulses von 0 V setzt also voraus, dass die Dämpfungsinduktivität 50 nicht als IC-Schaltung realisiert ist. Würde man eine "reale" Spule (axial oder planar) verwenden, wäre die Entkopplungskapazität 57 entbehrlich und damit z. B. ein gegen Masse geschalteter Schalter vorhanden, der zur Stopppulserzeugung geschlossen würde.

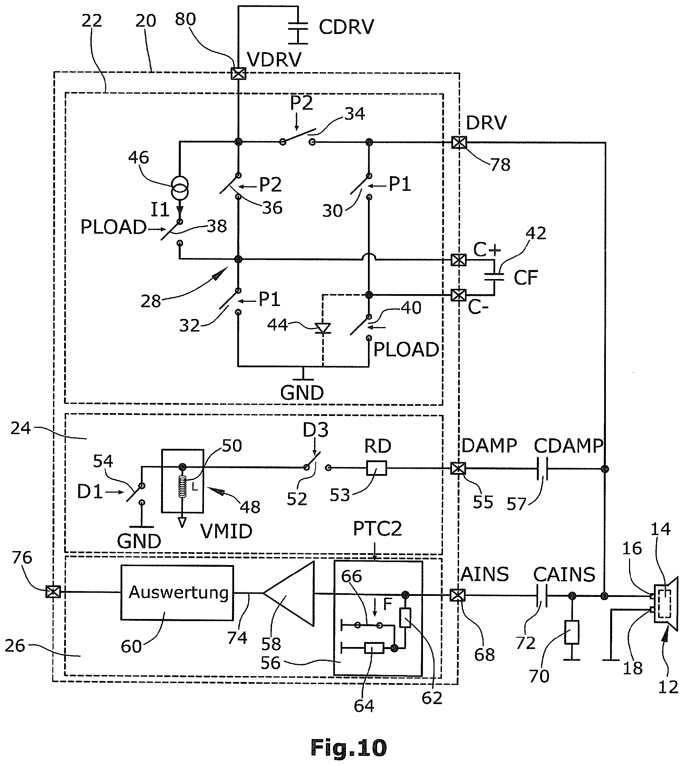

Schließlich zeigt Fig. 10 die Konstellation, in der gegen Ende der Ausschwingphase der integrierte (IC-)Teil des Filters 56 mit einer Filterkonstante arbeitet, die zum schnelleren Abklingen des mittleren Abklingsignals am Eingang 82 des Verstärkers führt. Der Schalter 66 des integrierten (IC-)Teils des Filters 56 ist in dieser Phase geschlossen.

Durch die Zwangsbeaufschlagung des Ausgangs 78 der Treiberstufe 22 am Ende eines Sendeintervalls mit kurzzeitig 0 V wird erreicht, dass am Signalanschluss 16 des Ultraschallwandlers 12 eine Spannung anliegt, die sich in demjenigen Größenbereich befindet, bei dem die Stufe 24 zur elektrischen Dämpfung des Ultraschallwandlers 12 bereits nahezu optimal arbeiten kann. Damit klingt das Signal am Signalanschluss 16 des Ultraschallwandlers 12 schneller ab. Die Umschaltung der Filterkonstante des Filters 56 sorgt zusätzlich dafür, dass der Eingang 82 des Verstärkers 58 während der Ausschwingphase schneller dem Ausschwingsignal folgt, so dass die Hüllkurve keine fehlerhaften Echos suggeriert.

### BEZUGSZEICHENLISTE

10 Ultraschallmesssystem
12 Ultraschallwandler
14 Schwingelement
16 Signalanschluss
18 Masseanschluss
20 Ansteuer- und Auswerteeinheit
22 Treiberstufe
24 Dämpfungsstufe
26 Auswertestufe
28 Brückenschaltung
30 Schalter
32 Schalter
34 Schalter
36 Schalter
38 Schalter
40 Schalter
42 Ladungsspeicherkapazität
44 Diode
46 Stromquelle
48 Impedanzkonverterschaltung
50 Dämpfungsinduktivität
52 Schalter
53 Widerstand
54 Schalter
55 Ausgang
56 Filter
57 Entkopplungskapazität
58 Verstärker
60 Auswerteschaltung
62 Widerständer
64 Widerstand
66 Schalter
68 Eingang
70 Widerstand
72 Entkopplungskapazität
74 Ausgang
76 Ausgang
78 Ausgang
80 Betriebsspannungspotential VDRV

## Patentansprüche

1. Ultraschallmesssystem, insbesondere zur Abstandsmessung und/oder als Parkhilfe bei Fahrzeugen, mit
- einem ein Schwingelement (14) aufweisenden, spannungsumsetzerlosen, elektroakustischen Ultraschallwandler (12), der alternierend als Ultraschallsender und als Ultraschallempfänger betreibbar ist und einen Signalanschluss (16), der entweder als Eingang oder als Ausgang des Ultraschallwandlers (12) dient, und einen Masseanschluss (18) aufweist, der mit Masse oder niederohmig mit Masse verbunden ist, und
- einer Ansteuer- und Auswerteeinheit (20) zur Anregung des Schwingelements (14) des Ultraschallwandlers (12) zum Aussenden von Ultraschallwellen für den Betrieb des Ultraschallwandlers (12) während eines Sendeintervalls zur anschließenden Deaktivierung der Anregung des Schwingelements (14) sowie zu dessen Dämpfung während einer Ausschwingphase und zum Empfang sowie zur Verarbeitung von Ultraschallwellen in einem Empfangsintervall,
- wobei die Ansteuer- und Auswerteeinheit (20) eine an eine Versorgungsgleichspannung (80) angeschlossene Brückenschaltung (28) mit steuerbaren Schaltern (30 bis 40) und einer umpolbaren Ladungsspeicherkapazität (42) zum alternierenden Ausgeben einer positiven und einer negativen Anregungsspannung für den Signalanschluss (16) des Ultraschallwandlers (12) während des Sendeintervalls an einem Ausgangsanschluss (78) einer Treiberstufe (22) der Ansteuer- und Auswerteschaltung (20) aufweist und
- wobei die Ansteuer- und Auswerteeinheit (20) mit dem Ende des Sendeintervalls für den Signalanschluss (16) des Ultraschallwandlers (12) durch Verbinden des Ausgangsanschlusses (78) mit Masse einen Spannungspuls von 0 V ausgibt.

2. Ultraschallmesssystem nach Anspruch 1, **dadurch gekennzeichnet, dass** die Ansteuer- und Auswerteeinheit (20) eine Dämpfungsinduktivität (50) aufweist, die durch die Ansteuer- und Auswerteeinheit (20) frühestens mit dem Ende des Sendeintervals aktiviert und während der Dauer der Ausschwingphase deaktivierbar ist.

3. Ultraschallmesssystem nach Anspruch 1, **dadurch gekennzeichnet, dass** die Ansteuer- und Auswerteeinheit (20) eine Dämpfungsinduktiviät (50) repräsentierende Impedanzkonverterschaltung (48) aufweist.

4. Ultraschallmesssystem nach Anspruch 3, **dadurch gekennzeichnet, dass** zwischen der Impedanzkonverterschaltung (48) und dem Signalanschluss (16) des Ultraschallwandlers (12) eine Entkopplungskapazität (57) zur Gleichspannungsentkopplung des Ultraschallwandlers (12) gegenüber der Impedanzkonverterschaltung (48) angeordnet ist und dass die Ansteuer- und Auswerteeinheit (20) frühestens mit dem Ende des Sendeintervalls die Impedanzkonverterschaltung (48) aktiviert und während der Dauer der Ausschwingphase deaktiviert.

5. Ultraschallmesssystem nach Anspruch 3 oder 4, **dadurch gekennzeichnet, dass** die Ansteuer- und Auswerteeinheit (20) einen Verstärker (58) zur zumindest während des Empfangsintervalls erfolgenden Verstärkung des Signals am Signalanschluss (16) des Ultraschallwandlers (12) aufweist.

6. Ultraschallmesssystem nach Anspruch 5, **dadurch gekennzeichnet, dass** der Verstärker (58) einen Eingang (68) für das Signal am Signalanschluss (16) des Ultraschallwandlers (12) aufweist und dass zwischen dem Signalanschluss (16) des Ultraschallwandlers (12) und dem Eingang (68) des Verstärkers (58) ein Filter (56) angeordnet ist.

7. Ultraschallmesssystem nach Anspruch 6, **dadurch gekennzeichnet, dass** das Filter (56) eine umschaltbare Filterkonstante zum schnelleren Abklingen des mittleren Abklingsignals am Signalanschluss (16) des Ultraschallwandlers (12) während der Ausschwingphase aufweist.

8. Ultraschallmesssystem nach Anspruch 7, **dadurch gekennzeichnet, dass** die Ansteuer- und Auswerteeinheit (20) frühestens mit Deaktivierung der Impedanzkonverterschaltung (48) oder Dämpfungsinduktivität (50) die umschaltbare Filterkonstante des Filters (56) aktiviert und die Filterkonstante mit Beendigung der Ausschwingphase, spätestens jedoch vor Beginn des Empfangsintervalls deaktiviert.

9. Ultraschallmesssystem nach einem der Ansprüche 1 bis 8, **dadurch gekennzeichnet, dass** die Ansteuer- und Auswerteeinheit (20) eine Stromquelle (46) zum Aufladen der Ladungsspeicherkapazität (42) während zumindest eines Teils der Dauer der Ausschwingphase und während des Empfangsintervalls aufweist.

## Claims

1. Ultrasound measuring system, in particular for distance measurement and/or as a parking assistant in vehicles, comprising
- an electro-acoustic ultrasound transducer (12) without a voltage converter and comprising a vibrating element (14), which transducer (12) is configured to be operated alternately as an ultrasound transmitter and as an ultrasound receiver, and a signal terminal (16) which serves either as an input or as an output of the ultrasound transducer (12), and a ground terminal (18) connected to ground or connected to ground with low resistivity, and
- a control and evaluation unit (20) for exciting the vibrating element (14) of the ultrasound transducer (12) for transmitting ultrasound waves for the operation of the ultrasound transducer (12) during a transmission interval for the subsequent deactivation of the excitation of the vibrating element (14) as well as for damping the same during a decay phase and for receiving, as well as for processing ultrasound waves in a receiving interval,
- wherein the control and evaluation unit (20) comprises a bridge circuit (28) connected to a supply DC voltage (80), said circuit comprising controllable switches (30 to 40) and a reversible charge storage capacitance (42) for alternately outputting a positive and a negative excitation voltage for the signal terminal (16) of the ultrasound transducer (12) during the transmission interval at an output terminal (78) of a driver stage (22) of the control and evaluation unit (20), and
- wherein the control and evaluation unit (20) outputs a voltage pulse of 0 V at the end of the transmission interval for the signal terminal (16) of the ultrasound transducer (12) by connecting the output terminal (78) to ground.

2. Ultrasound measuring system of claim 1, **characterized in that** the control and evaluation unit (20) comprises a damping inductance (50) which is activated by the control and evaluation unit (20) at the end of the transmission interval at the earliest and can be deactivated during the duration of the decay phase.

3. Ultrasound measuring system of claim 1, **characterized in that** the control and evaluation unit (20) comprises an impedance converter circuit (48) representing a damping inductance (50).

4. Ultrasound measuring system of claim 3, **characterized in that** a decoupling capacitance (57) is arranged between the impedance converter circuit (48) and the signal terminal (16) of the ultrasound transducer (12) for the DC voltage decoupling of the ultrasound transducer (12) with respect to the impedance converter circuit (48), and that the control and evaluation unit (20) activates the impedance converter circuit (48) at the end of the transmission interval at the earliest and deactivates the same during the duration of the decay phase.

5. Ultrasound measuring system of claim 3 or 4, **characterized in that** the control and evaluation unit (20) comprises an amplifier (58) for performing an amplification of the signal at the signal terminal (16) of the ultrasound transducer (12) at least during the receiving interval.

6. Ultrasound measuring system of claim 5, **characterized in that** the amplifier (58) comprises an input (68) for the signal at the signal terminal (16) of the ultrasound transducer (12), and that a filter (56) is arranged between the signal terminal (16) of the ultrasound transducer (12) and the input (68) of the amplifier (58).

7. Ultrasound measuring system of claim 6, **characterized in that** the filter (56) comprises a switchable filter constant for a faster decay of the mean decay signal at the signal terminal (16) of the ultrasound transducer (12) during the decay phase.

8. Ultrasound measuring system of claim 7, **characterized in that** the control and evaluation unit (20) activates the switchable filter constant of the filter (56) at the earliest upon the deactivation of the impedance converter circuit (48) or the damping inductance (50), and deactivates the filter constant at the end of the decay phase, but at the latest prior to the start of the receiving interval.

9. Ultrasound measuring system of one of claims 1 to 8, **characterized in that** the control and evaluation unit (20) comprises a power source (46) for charging the charge storage capacitance (42) during at least a part of the duration of the decay phase and during the receiving interval.

## Revendications

1. Système de mesure à ultrasons, en particulier pour la mesure de distances et/ou comme aide au stationnement pour des véhicules, comprenant
- un transducteur ultrasonore (12) électroacoustique sans convertisseur de tension, présentant un élément oscillant (14), qui peut être utilisé en alternance comme émetteur d'ultrasons et comme récepteur d'ultrasons et qui présente une borne de signal (16), qui sert soit d'entrée soit de sortie du transducteur ultrasonore (12), et une borne de masse (18) qui est raccordée à la masse ou qui est raccordée avec une faible valeur ohmique à la masse, et
- une unité de commande et d'évaluation (20) destinée à l'excitation de l'élément oscillant (14) du transducteur ultrasonore (12) pour l'émission d'ondes ultrasonores pour le fonctionnement du transducteur ultrasonore (12) pendant un intervalle d'émission pour la désactivation consécutive de l'excitation de l'élément oscillant (14) ainsi que pour son amortissement pendant une phase d'arrêt d'oscillation et pour la réception ainsi que pour le traitement d'ondes ultrasonores dans un intervalle de réception,
- l'unité de commande et d'évaluation (20) présentant un montage en pont (28) raccordé à une tension continue d'alimentation (80) avec des commutateurs (30 à 40) pouvant être commandés et avec une capacité (42) d'accumulation de charge repolarisable pour la délivrance alternée d'une tension d'excitation positive et d'une tension d'excitation négative pour la borne de signal (16) du transducteur ultrasonore (12) pendant l'intervalle d'émission sur une borne de sortie (78) d'un étage d'attaque (22) du circuit de commande et d'évaluation (20), et
- l'unité de commande et d'évaluation (20) délivrant une impulsion de tension de 0 V à la fin de l'intervalle d'émission pour la borne de signal (16) du transducteur ultrasonore (12) par raccordement de la borne de sortie (78) à la masse.

2. Système de mesure à ultrasons selon la revendication 1, **caractérisé en ce que** l'unité de commande et d'évaluation (20) présente une inductance d'amortissement (50) qui est activée par l'unité de commande et d'évaluation (20) au plus tôt à la fin de l'intervalle d'émission et qui peut être désactivée pendant la durée de la phase d'arrêt d'oscillation.

3. Système de mesure à ultrasons selon la revendication 1, **caractérisé en ce que** l'unité de commande et d'évaluation (20) présente un circuit de conversion d'impédance (48) représentant une inductance d'amortissement (50).

4. Système de mesure à ultrasons selon la revendication 3, **caractérisé en ce que**, entre le circuit de conversion d'impédance (48) et la borne de signal (16) du transducteur ultrasonore (12), il est disposé une capacité de découplage (57) pour le découplage de tension continue du transducteur ultrasonore (12) vis-à-vis du circuit de conversion d'impédance (48), et **en ce que** l'unité de commande et d'évaluation (20) est activée au plus tôt avec la fin de l'intervalle d'émission du circuit de conversion d'impédance (48) et est désactivée pendant la durée de la phase d'arrêt d'oscillation.

5. Système de mesure à ultrasons selon la revendication 3 ou 4, **caractérisé en ce que** l'unité de commande et d'évaluation (20) présente un amplificateur (58) pour l'amplification du signal sur la borne de signal (16) du transducteur ultrasonore (12) qui s'effectue au moins pendant l'intervalle de réception.

6. Système de mesure à ultrasons selon la revendication 5, **caractérisé en ce que** l'amplificateur (58) présente une entrée (68) pour le signal sur la borne de signal (16) du transducteur ultrasonore (12), et **en ce qu'**un filtre (56) est disposé entre la borne de signal (16) du transducteur ultrasonore (12) et l'entrée (68) de l'amplificateur (58).

7. Système de mesure à ultrasons selon la revendication 6, **caractérisé en ce que** le filtre (56) présente une constante de filtre commutable pour une décroissance plus rapide du signal de décroissance moyen sur la borne de signal (16) du transducteur ultrasonore (12) pendant la phase d'arrêt d'oscillation.

8. Système de mesure à ultrasons selon la revendication 7, **caractérisé en ce que** l'unité de commande et d'évaluation (20) active la constante de filtre commutable du filtre (56) au plus tôt avec la désactivation du circuit de conversion d'impédance (48) ou de l'inductance d'amortissement (50), et désactive la constante de filtre avec l'achèvement de la phase d'arrêt d'oscillation, mais au plus tard avant le début de l'intervalle de réception.

9. Système de mesure à ultrasons selon l'une des revendications 1 à 8, **caractérisé en ce que** l'unité de commande et d'évaluation (20) présente une source de courant (46) pour le chargement de la capacité (42) d'accumulation de charge pendant au moins une partie de la durée de la phase d'arrêt d'oscillation et pendant l'intervalle de réception.
